# FASCICULE DE BREVET EUROPEEN

(11) **EP 1 768 189 B1**
(45) Date de publication et mention de la délivrance du brevet: **12.11.2008**
(21) Numéro de dépôt: 06121151.2
(22) Date de dépôt: 22.09.2006
(51) Int. Cl.: H01L 29/788, H01L 29/423

(54) **Mémoire non volatile reprogrammable**
Wiederprogrammierbare nichtschwebende Speicheranordnung
Reprogrammable non volatile memory device

(30) Priorité: 23.09.2005 FR 0552849
(43) Date de publication de la demande: 28.03.2007
(73) Titulaire: ST MICROELECTRONICS S.A., 92120 Montrouge (FR); STMicroelectronics (Rousset) SAS, 13790 Rousset (FR); UNIVERSITE D'AIX-MARSEILLE I, 13331 MARSEILLE CEDEX (FR)
(72) Inventeur: Bouchakour, Rachid, 13012, Marseille (FR); Bidal, Virginie, 13090, Aix en Provence (FR); Candelier, Philippe, 38190, Saint Mury Monteymond (FR); Fournel, Richard, 38660, Lumbin (FR); Gendrier, Philippe, 38000, Grenoble (FR); Laffont, Romain, 13013, Marseille (FR); Masson, Pascal, 13004, Marseille (FR); Mirabel, Jean-Michel, 13480, Cabries (FR); Régnier, Arnaud Avenue Paul Julien, Bâtiment A, No. 11 13100, Le Tholonet (FR)
(74) Mandataire: de Beaumont, Michel

(56) Documents cités:
- EP-A- 1 271 657
- WO-A-03/088366
- US-A- 5 554 552

## Description

### Domaine de l'invention

La présente invention concerne une mémoire non volatile et plus particulièrement un point mémoire reprogrammable.

### Exposé de l'art antérieur

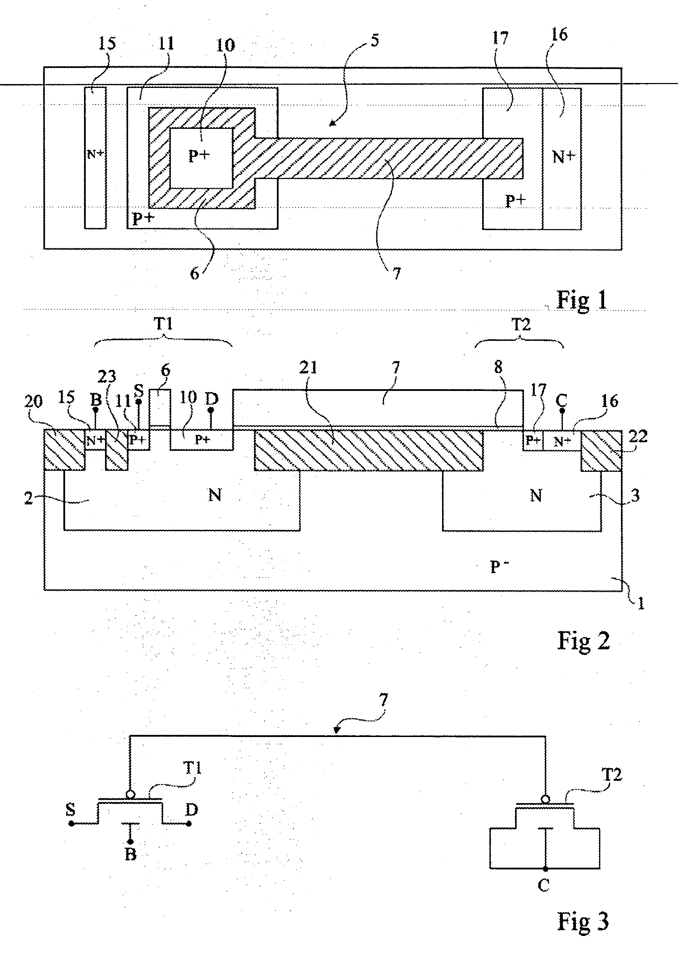

Les figures 1 et 2 sont respectivement une vue de dessus et une vue en coupe d'un point mémoire non volatil. Ce point mémoire est décrit dans la demande internationale WO 03/088366 de la demanderesse. Ce point mémoire est formé dans et au-dessus d'un substrat semiconducteur 1, par exemple en silicium faiblement dopé de type P. Deux caissons 2 et 3 dopés de type N sont formés respectivement sur la gauche et la droite en figure 2. Une grille flottante 5, par exemple en silicium polycristallin, est placée sur le substrat 1. La grille flottante 5 comprend une portion 6 sensiblement annulaire placée au-dessus du caisson 2 et qui se prolonge par une portion rectiligne 7 dont l'extrémité est placée au-dessus du caisson 3. La grille flottante 5 est isolée du substrat par une fine couche isolante 8, par exemple d'oxyde de silicium. Une zone 10 fortement dopée de type P est placée en surface du caisson N 2 à l'intérieur de la portion annulaire 6 en vue de dessus. Une zone 11 fortement dopée de type P est placée en surface du caisson N 2 tout autour de la portion annulaire 6 en vue de dessus. Une zone de contact de caisson 15 fortement dopée de type N est placée en surface du caisson N 2. De même, une zone de contact de caisson 16 fortement dopée de type N est formée en surface du caisson N 3 sur la droite de ce dernier. Une zone 17 fortement dopée de type P est formée en surface du caisson N 3 sur la gauche de la zone N⁺ 16 et tout autour, en vue de dessus, de la portion rectiligne 7 de la grille flottante 5. Les caissons N 2 et 3 sont entourés d'une zone isolante formée dans la partie supérieure du substrat 1. Trois portions 20, 21 et 22 de cette zone isolante sont visibles respectivement à gauche du caisson 2, entre les caissons 2 et 3 et à droite du caisson 3. De plus, la zone N⁺ 15 et la zone P⁺ 11 sont séparées par une zone isolante 23 formée dans la partie supérieure du caisson N 2. Les zones fortement dopées 10, 11, 15, 16 et 17, ainsi que la grille flottante 5 sont recouvertes de couches de siliciure non représentées.

La figure 3 est un schéma électrique équivalent du point mémoire des figures 1 et 2. La portion annulaire 6 de la grille flottante 5 constitue la grille d'un transistor à canal P (PMOS) T1. Les zones P⁺ 10 et 11 constituent respectivement une zone de drain D et une zone de source S. Le caisson N 2 constitue le "substrat" B du transistor T1. L'extrémité de la portion rectiligne 7 de la grille flottante 5 constitue la grille d'un transistor PMOS T2. La zone P⁺ 17 est à la fois la zone de source et la zone de drain du transistor T2. Les zones de source et de drain sont court-circuitées et reliées au substrat du transistor T2, constitué par le caisson N 3, par l'intermédiaire de la couche de siliciure recouvrant les zones P⁺ 16 et N⁺ 17. Le caisson N 3 et les zones P⁺ 16 et N⁺ 17 constituent une électrode de commande C du point mémoire. Les grilles des transistors PMOS T1 et T2 sont reliées par l'intermédiaire de la portion 7 de grille flottante. Les références B, D, S et C ont été reportées en figure 2 par souci de clarté.

La programmation ou l'effacement du point mémoire consiste respectivement à injecter des charges électriques dans la grille flottante 5 ou à les éliminer. Les procédés de programmation, d'effacement et de lecture d'un tel point mémoire sont décrits en détail dans la demande internationale susmentionnée.

Un problème bien connu des points mémoires non volatils est la "fuite" des charges stockées dans la grille flottante. Dans l'exemple de point mémoire décrit précédemment, les charges stockées dans la grille flottante 5 ont tendance à passer, par effet tunnel, à travers la couche isolante 8 vers les régions semiconductrices des transistors T1 et T2. Ces fuites de charge par effet tunnel sont d'autant plus importantes que la couche isolante 8 est mince. De plus, les multiples programmations et effacements de tels points mémoire ont pour effet de détériorer la qualité de la fine couche isolante 8 et d'augmenter encore davantage les fuites par effet tunnel.

Le brevet US 5 554 552 décrit un point mémoire dans lequel la grille flottante comprend des zones P et des zones N.

### Résumé de l'invention

Un objet de la présente invention est de prévoir un point mémoire non volatil incluant une grille flottante qui présente une très bonne capacité de rétention des charges électriques stockées dans cette dernière.

Un autre objet de la présente invention est de prévoir un tel point mémoire qui conserve une très bonne capacité de rétention des charges électriques quel que soit le nombre de programmations et d'effacements réalisés.

Un autre objet de la présente invention est de prévoir un tel point mémoire de structure simple.

Pour atteindre ces objets, la présente invention prévoit un point mémoire non volatil incluant une grille flottante placée au-dessus d'un substrat semiconducteur, la grille flottante comprenant des portions actives isolées du substrat par des couches isolantes fines, et des portions inactives isolées du substrat par des couches isolantes épaisses non traversables par des électrons, les portions actives étant majoritairement dopées de type P et les portions inactives comprenant au moins une zone dopée de type N constituant une partie d'une jonction PN.

Selon un mode de réalisation du point mémoire susmentionné, les couches isolantes épaisses sont placées dans la partie supérieure du substrat et isolent plusieurs zones du substrat semiconducteur telles que des caissons.

Selon une variante de réalisation du point mémoire décrit ci-dessus, le point mémoire comprend en outre des moyens de transfert d'électrons de ladite zone dopée de type N, constituant un puits de stockage d'électrons injectés dans la grille flottante lors d'une opération de programmation, vers tout ou partie des portions actives.

Selon un mode de réalisation du point mémoire susmentionné, lesdits moyens de transfert comprennent au moins une électrode de couplage placée à proximité de ladite au moins une zone dopée de type N et séparée de cette dernière par une portion isolante, ladite au moins une électrode de couplage étant reliée à une borne de polarisation.

Selon une variante de réalisation du point mémoire décrit ci-dessus, des premier et second caissons d'un premier type de dopage sont placés dans la partie supérieure du substrat d'un second type de dopage, la grille flottante comprenant une portion active annulaire placée au-dessus du premier caisson, une portion non active placée au-dessus d'une zone isolante placée dans la partie supérieure du substrat entre les premier et second caissons, et une portion active d'extrémité placée au-dessus du second caisson, des zones de drain et de source du second type de dopage étant placées en surface du premier caisson respectivement à l'intérieur et à l'extérieur, en vue de dessus, de la portion active annulaire.

Selon une variante de réalisation du point mémoire susmentionné, la portion active annulaire et la portion active d'extrémité sont dopées de type P et la portion inactive est dopée de type N.

Selon une variante de réalisation du point mémoire susmentionné, la portion active annulaire et la portion active d'extrémité sont dopées de type P, et la portion inactive comprend plusieurs zones dopées de type N séparées les unes des autres par des zones dopées de type P.

Selon une variante de réalisation du point mémoire décrit ci-dessus, la portion active annulaire et la portion active d'extrémité sont dopées de type P, la portion inactive comprenant une portion rectiligne dopée de type P présentant des excroissances latérales dont les extrémités sont dopées de type N.

Selon une variante de réalisation du point mémoire décrit ci-dessus, le point mémoire comprend des zones d'électrode placées à proximité de la portion inactive et présentant des excroissances placées à proximité des zones dopées de type N.

Selon une variante de réalisation du point mémoire décrit ci-dessus, le point mémoire comprend un empilement d'une première couche isolante, d'une grille flottante, d'une seconde couche isolante et d'une grille de contrôle, l'empilement étant placé au-dessus d'un substrat semiconducteur perpendiculairement à une bande supérieure du substrat entourée par une zone isolante placée dans la partie supérieure de substrat, des zones de source/drain étant formées dans la bande supérieure de substrat de part et d'autre de l'empilement, la partie centrale de la grille flottante placée au-dessus de la bande supérieure de substrat constituant une portion active dopée de type P, et les portions d'extrémité de la grille flottante constituant des portions inactives dopées de type N.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 sont respectivement une vue de dessus et une vue en coupe d'un point mémoire non volatil, précédemment décrit ;
la figure 3 est un schéma électrique équivalent du point mémoire représenté en figures 1 et 2 ;
les figures 4A et 4B sont respectivement une vue de dessus et une vue en coupe d'un point mémoire, du type de celui représenté en figures 1 et 2, selon un mode de réalisation de la présente invention ;
la figure 5 est un diagramme illustrant les bandes d'énergie de la grille flottante du point mémoire représenté en figures 4A et 4B ;
la figure 6 est un schéma électrique équivalent du point mémoire représenté en figures 4A et 4B ;
la figure 7 est une vue de dessus d'un point mémoire, du type de celui représenté en figures 1 et 2, selon un autre mode de réalisation de la présente invention ;
la figure 8 est un schéma électrique équivalent du point mémoire représenté en figure 7 ;
la figure 9 est une vue de dessus d'un point mémoire, du type de celui représenté en figures 1 et 2, selon un autre mode de réalisation de la présente invention ;
la figure 10 est un schéma électrique équivalent du point mémoire représenté en figure 9 ; et
les figures 11A, 11B et 11C sont respectivement une vue de dessus, une première vue en coupe et une seconde vue en coupe d'un autre type de point mémoire non volatil selon la présente invention.

### Description détaillée

Par souci de clarté, de mêmes éléments ont été désignés par de mêmes références aux différentes figures et, comme cela est habituel dans la représentation des circuits intégrés, les figures 1, 2, 4A, 4B, 7, 9, 11A, 11B et 11C ne sont pas tracées à l'échelle.

Afin de limiter les fuites des électrons stockés dans la grille flottante d'un point mémoire non volatil, la présente invention prévoit de "piéger", pendant les périodes de rétention, les charges de la grille flottante dans des emplacements de cette dernière fournis sur des couches isolantes épaisses non traversables par des électrons. De tels emplacements de piégeage sont des puits à électrons formés au moyen d'une ou plusieurs jonctions semiconductrices PN réalisées dans la grille flottante.

Des exemples de points mémoire non volatils selon la présente invention sont décrits ci-après.

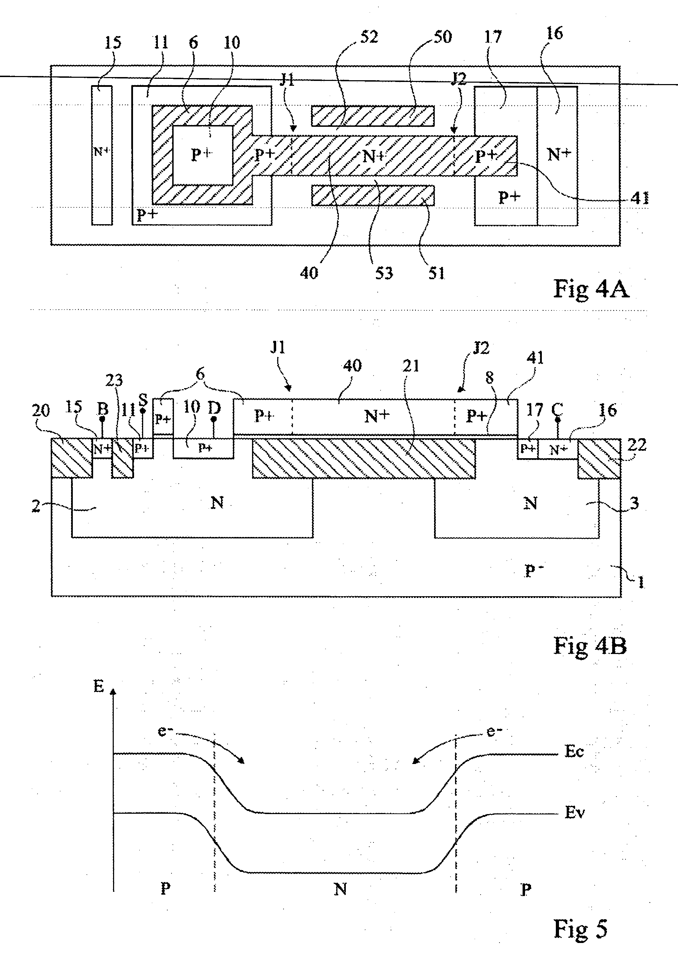

Les figures 4A et 4B sont respectivement une vue de dessus et une vue en coupe d'un point mémoire identique à celui représenté en figures 1 et 2 excepté que le dopage de la grille flottante 5 n'est pas uniforme et qu'elle n'est pas recouverte d'une couche de siliciure. La portion de la grille flottante 5 placée au-dessus de la zone isolante 21, ci-après appelée portion intermédiaire 40, est fortement dopée de type N. L'extrémité de la portion rectiligne 7, ci-après appelée portion d'extrémité 41, est fortement dopée de type P. La portion annulaire 6 est quant à elle fortement dopée de type P. Deux jonctions PN J1 et J2 sont ainsi formées d'une part par la portion annulaire 6 et la portion intermédiaire 40 et d'autre part par la portion intermédiaire 40 et la portion d'extrémité 41.

De façon générale, une grille flottante d'un point mémoire non volatil est une région conductrice, non connectée à une borne extérieure, formée au moins en partie au-dessus de régions semiconductrices avec interposition d'une couche isolante. Cette grille flottante a pour fonction de rendre passante ou non une région de canal d'un transistor MOS, entre des régions de drain et de source. La portion de la grille flottante placée au-dessus d'une telle région de canal est appelée dans la présente description portion active. On appellera aussi portions actives les portions de la grille flottante placées au-dessus de couches isolantes à travers lesquelles transitent des électrons lors d'opérations de programmation ou d'effacement. De telles portions actives constituent des zones de réception/émission d'électrons. Les autres portions de la grille flottante sont dites inactives.

Dans l'exemple de point mémoire représenté en figure 4B, la portion annulaire 6 est une zone de réception d'électrons lors d'opérations de programmation par électrons chauds, et elle constitue la grille du transistor T1. La portion d'extrémité 41 est une zone d'émission lors d'opérations d'effacement ou une zone de réception lors d'opérations de programmation par effet tunnel de Fowler-Nordheim. La portion annulaire 6 et la portion d'extrémité 41 sont donc des portions actives de la grille flottante. La portion intermédiaire 40 est quant à elle une portion inactive de la grille flottante.

La figure 5 est un diagramme d'énergie illustrant la forme de la bande de valence Ev et de la bande de conduction Ec de la portion rectiligne de la grille flottante 5, en l'absence de polarisation des électrodes du point mémoire. On constate que la portion intermédiaire N⁺ 40 constitue un "puits" à électrons. La quantité d'électrons pouvant être stockés dans le puits est fonction, entre autres, de la concentration en éléments dopants de chacune des portions de la grille flottante. En première approximation, la quantité d'électrons pouvant être stockés dans un puits est proportionnelle à la quantité de donneurs ionisés présents dans la portion intermédiaire N⁺ 40 au niveau des zones de charge d'espace des jonctions J1 et J2 à l'équilibre thermodynamique, c'est-à-dire en dehors de tout stockage d'électrons dans la grille flottante.

Dans la présente description d'un point mémoire non volatil comprenant une grille flottante, une couche isolante placée entre cette grille flottante et une zone conductrice, telle qu'une partie du substrat dans lequel est formé le point mémoire, est considérée comme épaisse dans la mesure où elle ne peut pas être traversée par des électrons. L'épaisseur minimale que doit avoir une telle couche isolante est fonction de la tension maximale susceptible d'exister à travers cette couche isolante entre la grille flottante et une zone conductrice voisine. On pourra considérer qu'une couche isolante séparant la grille flottante et une zone conductrice est épaisse dans la mesure où elle est au moins 10 fois plus épaisse que les couches isolantes "fines" du point mémoire traversées par des électrons lors de phases de programmation ou d'effacement.

Dans l'exemple de point mémoire représenté en figure 4B, les portions actives 6 et 41 sont isolées du substrat par la fine couche isolante 8 et la portion inactive 40 est isolée du substrat par la portion isolante 21 recouverte par la fine couche isolante 8. La fine couche isolante a par exemple une épaisseur de 5 nanomètres et la portion isolante 21 une épaisseur de 0,35 micromètre. Il y a alors un rapport 70 entre les épaisseurs des couches isolantes fines et épaisses placées respectivement sous les zones actives et sous les zones inactives.

Un avantage d'un point mémoire selon la présente invention est que le confinement de tout ou partie des électrons stockés dans la grille flottante au niveau d'une zone inactive isolée du substrat par une couche épaisse permet d'éliminer tout risque de fuite par effet tunnel de ces électrons pendant les périodes de rétention.

On notera que le confinement des électrons dans la portion intermédiaire N⁺ 40 a pour effet de limiter l'influence des électrons sur la polarisation de la grille du transistor T1. En d'autres termes, cela diminue, en valeur absolue, la tension de seuil du transistor T1, appelée VT4 dans la demande internationale susmentionnée. En conséquence, le courant de lecture traversant le transistor T1 est plus faible que celui constaté pour un point mémoire comprenant une grille flottante uniformément dopée. Afin de pallier cet inconvénient, des zones d'électrodes de couplage 50 et 51 peuvent être placées en regard de la portion intermédiaire N⁺ 40 et isolées de cette dernière par des portions isolantes 52 et 53. Les électrodes de couplage 50 et 51 sont dans cet exemple placées au-dessus de la zone isolante 21. Par couplage capacitif, il est possible de faire varier le potentiel électrique de la portion intermédiaire N 40 en appliquant une tension adéquate sur les zones d'électrodes de couplage 50 et 51. Les électrodes de couplage 50 et 51 sont par exemple constituées de silicium polycristallin comme la grille flottante 5.

Durant des opérations de lecture ou d'effacement, on peut faire sortir les électrons du puits formé au niveau de la portion intermédiaire N 40 en polarisant les zones d'électrode de couplage 50 et 51 à un potentiel bas, typiquement à la masse. Une telle polarisation de la portion intermédiaire N 40 permet de faire "remonter" les niveaux d'énergie des bandes de valence Ev et de conduction Ec de cette portion, et de réduire ou supprimer le puits à électrons. Les électrons présents dans la grille se répartissent alors dans la grille flottante en fonction des couplages capacitifs entre la grille flottante et les zones conductrices situées à proximité de la grille flottante. Outre le couplage capacitif avec les zones d'électrode de couplage 50, 51, le potentiel de la grille flottante 5 est fonction des couplages capacitifs formés avec deux zones de commande du point mémoire représenté en figures 4A et 4B. La première zone de commande est constituée du caisson N 3 et de la zone P⁺ 17 entourant la portion d'extrémité 41 de la grille flottante. La seconde zone de commande est constituée du caisson N 2 et des zones P⁺ de source/drain 10 et 11.

Durant une opération de programmation par "électrons chauds", il peut être intéressant de "creuser" les puits à électrons en positionnant les zones d'électrodes de couplage à un potentiel relativement élevé.

Durant une opération de programmation par effet Fowler Nordheim, du côté du caisson N 3, il est préférable au contraire de polariser les zones d'électrodes de couplage 50 et 51 à un potentiel bas tel que la masse.

Par ailleurs, lorsqu'aucune opération n'est effectuée sur le point mémoire, on applique de préférence un potentiel élevé sur les zones d'électrodes de couplage afin de creuser les puits à électrons et d'accroître ainsi les capacités de rétention du point mémoire.

A titre indicatif, et non limitatif, les tensions de polarisation des diverses parties d'un point mémoire tel que représenté en figures 4A et 4B sont données ci-après. Les tensions appliquées sur la zone P⁺ de drain, sur la zone P⁺ de source, sur le caisson N 2, sur le caisson N 3 et sur les électrodes de commande 50, 51 sont respectivement appelées Vd, Vs, Vb, Vc et Vp.

| Opération | Vs | Vb | Vd | Vc | Vp |
|---|---|---|---|---|---|
| Programmation électrons chauds | 5 V | 5 V | 0 V | 5/0 V | 2,5 V |
| Programmation Fowler Nordheim | 11 V | 11 V | 11 V | 0 V | 0 V |
| Effacement | 0 V | 0 V | 0 V | 7 V | 0 V |
| Lecture | 2,5 V | 2,5 V | 1,5 V | 2,5 V | 0 V |
| Aucune (rétention) | 2,5 V | 2,5 V | 2,5 V | 2,5 V | 2,5 V |

Les électrodes de couplage 50 et 51 polarisées à des potentiels adéquats constituent des moyens de transfert d'électrons vers les portions annulaire 6 et d'extrémité 41. D'autres moyens de transfert d'électrons d'une portion inactive vers une portion active de la grille flottante peuvent être utilisés. Un autre exemple de moyen de transfert d'électrons consiste à polariser le caisson N 3, les zones P⁺ de drain/source 10, 11 et le caisson N 2 de façon que, par couplages capacitifs, les différentes portions de la grille flottante soient à des potentiels différents et qu'un gradient de potentiel soit créé entre la portion d'extrémité 41 et la portion annulaire 6. Lors d'une opération de lecture, on fait alors en sorte que le potentiel de la portion d'extrémité 41 soit plus faible que celui de la portion annulaire 6 et inversement lors d'une opération d'effacement.

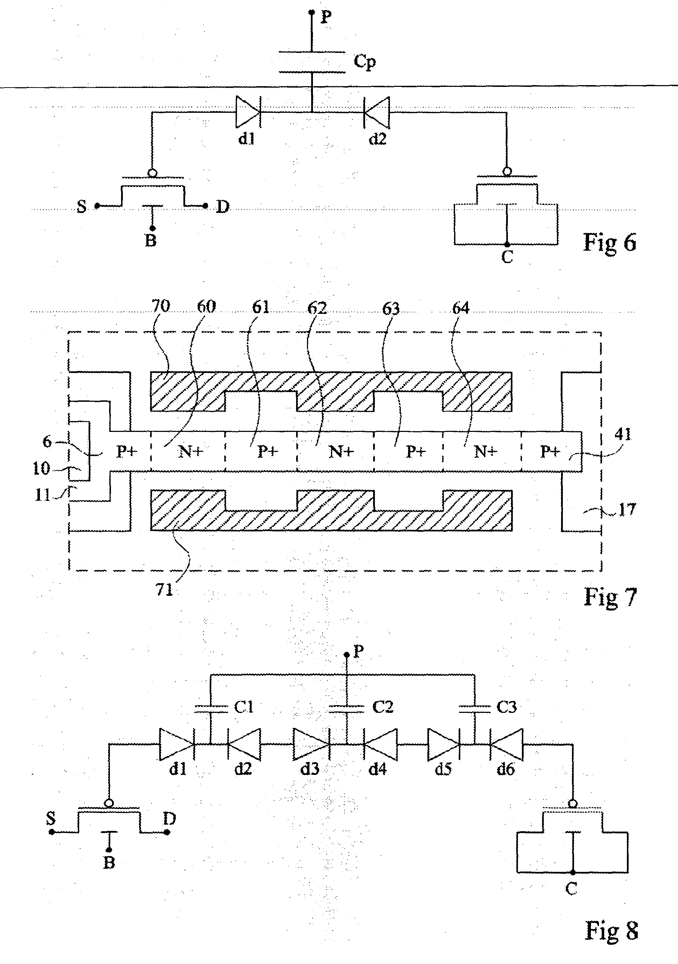

La figure 6 est un schéma électrique équivalent du point mémoire représenté en figures 4A et 4B. Comme dans le schéma de la figure 3, le point mémoire comprend un transistor T1 dont la source, le drain et le substrat peuvent être polarisés séparément, ainsi qu'un transistor T2 dont la source, le drain et le substrat sont reliés à une électrode de commande C. Les grilles des transistors T1 et T2 sont reliées par deux diodes d1 et d2 tête-bêche. Les cathodes des diodes d1 et d2 sont reliées à une électrode d'un condensateur Cp dont l'autre électrode est reliée à une borne de polarisation P. La diode d1 correspond à la jonction PN J1 et la diode d2 à la jonction PN J2. Le condensateur Cp correspond au condensateur formé par la portion intermédiaire N 40, les zones d'électrodes de couplage 50 et 51 et les fines portions isolantes 52 et 53.

Le nombre d'électrons pouvant être piégés dans un puits n'est pas infini. Par ailleurs, le nombre d'électrons stockés dans une grille flottante est généralement bien supérieur au nombre d'électrons pouvant être stockés dans un unique puits. Dans le cas où la grille comprend des jonctions PN constituées de zones P et N fortement dopées, avec des concentrations supérieures à 10¹⁷ atomes/cm³, il peut y avoir un rapport 10 entre le nombre d'électrons stockés dans la grille flottante et le nombre d'électrons stockés dans un puits. Afin d'augmenter le nombre d'emplacements de piégeage d'électrons dans la grille flottante, il est possible de prévoir un grand nombre de jonctions PN au-dessus de la zone isolante 21 du point mémoire représenté en figure 4B, entre la portion annulaire 6 et la portion d'extrémité 41 de la grille flottante.

La figure 7 est une vue de dessus d'un tel point mémoire dans lequel la portion annulaire 6 et la portion d'extrémité 41 sont comme précédemment fortement dopées de type P et dans lequel l'unique portion intermédiaire 40 est remplacée par cinq portions intermédiaires 60, 61, 62, 63 et 64 alternativement dopées de type N et de type P. Six jonctions PN J1 à J6 sont alors formées au-dessus de la zone isolante 21. La grille flottante comprend 3 puits à électrons placés au niveau de chacune des portions intermédiaires dopées de type N 60, 62 et 64.

Afin, comme précédemment, de supprimer ou de creuser les puits à électrons, des zones d'électrodes de couplage 70 et 71 sont placées de part et d'autre de l'ensemble des portions intermédiaires 60 à 64. Chaque zone d'électrode de couplage 70 et 71 a dans cet exemple une forme sensiblement rectiligne et présente des avancées ou excroissances en regard des portions intermédiaires N⁺ 60, 62 et 64. Afin de pouvoir moduler de façon efficace la "profondeur" des puits à électrons, la forme des zones d'électrode de couplage 70 et 71 doit être telle que le couplage capacitif soit plus important avec les portions intermédiaires N⁺ 60, 62 et 64 qu'avec les portions intermédiaires P⁺ 61 et 63.

Le fonctionnement d'un tel point mémoire est identique à celui décrit précédemment pour le point mémoire représenté en figures 4A et 4B.

La figure 8 est un schéma électrique équivalent du point mémoire de la figure 7. Ce point mémoire comprend comme précédemment deux transistors T1 et T2. Les grilles de ces transistors T1 et T2 sont reliées par six diodes, tête-bêche deux à deux. Les cathodes de chaque couple de diodes tête-bêche sont reliées à une électrode d'un condensateur C1, C2 ou C3. Les autres électrodes des condensateurs C1, C2 et C3 sont reliées ensemble à une borne de polarisation P.

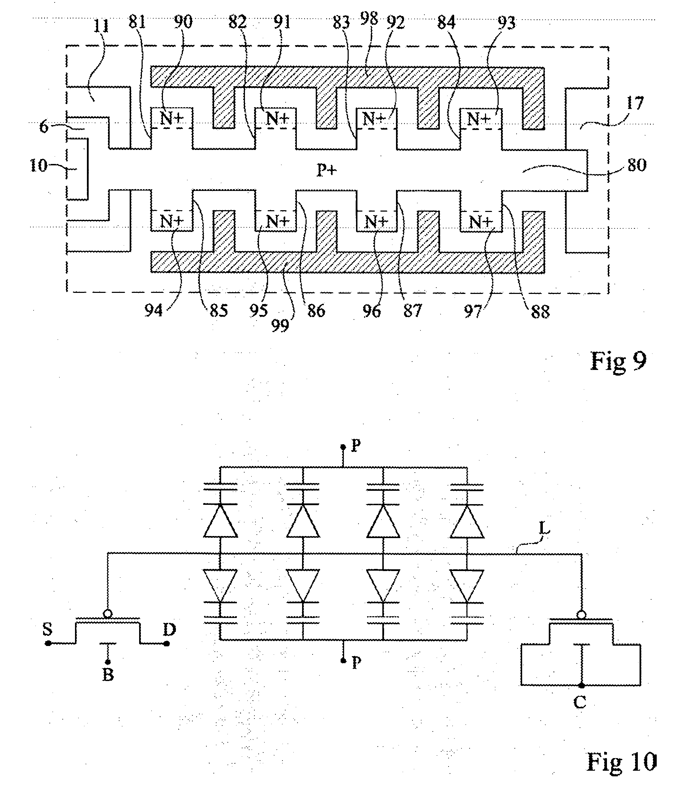

La figure 9 est une vue de dessus d'une variante de réalisation du point mémoire représenté en figures 4A et 4B dans lequel l'unique portion intermédiaire 40 est remplacée par une portion rectiligne 80 présentant des excroissances latérales. Dans cet exemple, quatre excroissances latérales 81, 82, 83 et 84 sont représentées sur le haut de la figure et quatre excroissances latérales 85, 86, 87 et 88 sont représentées sur le bas de la figure 9. La portion rectiligne 80 est fortement dopée de type P et les extrémités 90 à 98 des excroissances latérales 81 et 88 sont fortement dopées de type N. La grille flottante comprend 8 jonctions PN formées au niveau de chacune des excroissances latérales 81 à 88.

Comme précédemment, afin de moduler la profondeur des puits à électrons, deux zones d'électrodes de couplage 98 et 99 sont placées respectivement en regard des excroissances 81 à 84 et des excroissances 85 à 88. Les zones d'électrode de couplage 98 et 99 comprennent chacune une portion sensiblement rectiligne présentant des excroissances latérales à la forme d'un peigne venant s'insérer entre les excroissances latérales de la grille flottante.

La figure 10 est un schéma électrique équivalent du point mémoire de la figure 9. Ce point mémoire comprend comme précédemment deux transistors T1 et T2. Les grilles de ces deux transistors sont reliées par une ligne conductrice L. La ligne conductrice L est connectée aux anodes de huit diodes d1 à d8. Chaque diode d1 à d8 est, du côté de sa cathode, reliée à une électrode d'un condensateur C1 à C8. Les autres électrodes des condensateurs C1 à C8 sont reliées ensemble à une borne de polarisation P.

Le fonctionnement du point mémoire présenté en figure 9 est identique à celui du point mémoire représenté en figures 4A et 4B.

D'autres variantes de réalisation du point mémoire représenté en figures 4A/4B peuvent être imaginées. La portion intermédiaire 40 peut être remplacée par d'autres structures présentant des puits à électrons au niveau desquels un piégeage peut être réalisé.

Par ailleurs, la portion d'extrémité 41, fortement dopée de type P dans les exemples de réalisation précédemment décrits, peut inclure à son extrémité une zone dopée de type N. Cette zone N permet de faciliter les opérations d'effacement et notamment de réduire la tension d'effacement utilisée. La présence de cette zone N crée une jonction P/N et donc un puits à électrons qui est séparé du caisson 3 par la fine couche isolante 8. Cela est préjudiciable pour la rétention des électrons "stockés" dans ce puits. Afin de ne pas trop amputer les capacités de rétention du point mémoire, il est alors souhaitable qu'il y ait au moins 2 ou 3 jonctions P/N placées au-dessus de la zone isolante 21.

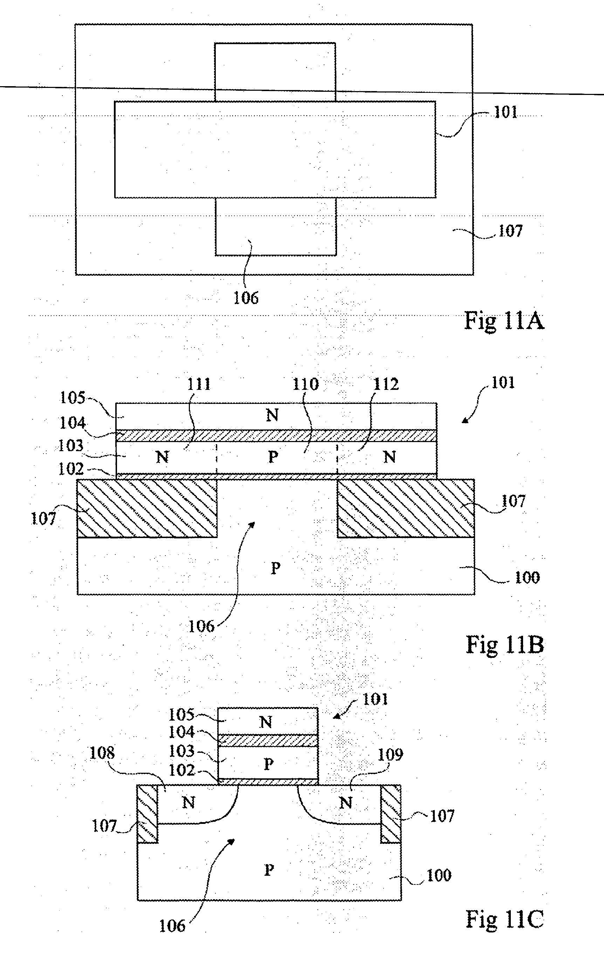

Les figures 11A, 11B et 11C sont respectivement une vue de dessus, une première vue en coupe et une seconde vue en coupe d'un point mémoire non volatil selon la présente invention, d'un autre type que celui décrit précédemment. Ce point mémoire, de type FLASH, est formé dans et au-dessus d'un substrat 100 de type P. Il comprend un empilement 101 d'une fine couche isolante 102, d'une grille flottante 103, d'une couche isolante 104 et d'une grille de contrôle 105. L'empilement 101, de forme sensiblement rectangulaire, est placé au-dessus du substrat sensiblement perpendiculairement à une bande supérieure du substrat 106 entourée par une zone isolante 107 placée dans la partie supérieure du substrat. Les portions de la bande supérieure de substrat 106 situées de part et d'autre de l'empilement 101 sont dopées de type N et constituent des zones de source 108 et de drain 109.

La programmation d'un tel point mémoire, visant à injecter des électrons dans la grille flottante 103, est de type à "électrons chauds". Le substrat P 100 et la zone de source 108 sont polarisés à un faible potentiel, par exemple à la masse, et la zone de drain 109 et la grille de contrôle 105 polarisées à une tension élevée, par exemple 5 V. La présence d'un fort courant source/drain entraîne la création de paires électrons-trous dans la zone de canal, sous l'empilement 101, et un passage d'électrons à travers la fine couche isolante 102 jusque dans la grille flottante 103.

L'effacement d'un tel point mémoire, visant à éliminer les électrons présents dans la grille flottante, est de type "Fowler-Nordheim". Le substrat 100 et la grille de contrôle 105 sont polarisés à un faible potentiel, par exemple à la masse, la zone de source 108 est polarisée à un potentiel élevé, par exemple 8 V, et la zone de drain est en haute impédance.

Lors de la lecture d'un tel point mémoire, la grille de contrôle 105 est polarisée à un potentiel relativement élevé, par exemple 3 V, le substrat 100 est polarisé à la masse et une tension, par exemple de 1 V, est appliquée entre les zones de source 108 et de drain 109.

Selon un aspect de la présente invention, la portion centrale 110 de la grille flottante 103, placée au-dessus de la bande supérieure de substrat 106, est dopée de type P et les portions d'extrémité 111 et 112 de la grille flottante, placées au-dessus de la zone isolante 107, sont dopées de type N. Les deux portions d'extrémité 111 et 112 constituent des puits à électrons. Ainsi, les électrons injectés dans la grille flottante sont stockés au niveau des portions d'extrémité 111 et 112.

Les exemples de tensions de polarisation donnés précédemment pour les opérations de lecture et d'effacement permettent de transférer les électrons stockés dans les portions d'extrémité 111 et 112 vers la portion centrale 110. D'autres moyens de transfert des électrons hors des portions d'extrémité peuvent être prévus. On pourra par exemple placer des électrodes de couplage de part et d'autre des portions d'extrémité et polariser ces dernières à des potentiels adéquats afin de "vider" ou éventuellement de "creuser" les puits à électrons.

La portion centrale est une zone de réception/émission d'électrons lors de phases de programmations ou d'effacements ainsi qu'une grille de transistor en interagissant par couplage capacitif avec les zones dopées de la bande supérieure de substrat 106. La portion centrale est donc une portion active de la grille flottante. Les portions d'extrémité 111 et 112 sont quant à elles des portions inactives utilisées pour le stockage d'électrons.

Les électrons sont ainsi stockées dans des portions de la grille flottante séparées du substrat par la zone isolante 107 qui constitue une couche isolante "épaisse" ne pouvant être traversée par des électrons.

De plus, les électrons sont stockés loin des couches isolantes "fines" du point mémoire à travers lesquelles transitent des électrons lors d'opérations de programmation ou d'effacement.

Un avantage d'un point mémoire selon la présente invention est donc qu'il présente une très bonne capacité de rétention des charges électriques, et ceci quel que soit le nombre de programmations et d'effacements du point mémoire.

Bien entendu, la présente invention est susceptible de diverses variantes et modifications qui apparaîtront à l'homme de l'art. En particulier, la présente invention n'est pas limitée aux types de points mémoire représentés en figures 4A/4B et 11A/11B/11C. La présente invention s'applique à tout type de point mémoire non volatil comprenant une grille flottante présentant une portion inactive isolée d'un substrat semiconducteur par une couche isolante épaisse ne pouvant être traversée par des électrons.

## Revendications

1. Point mémoire non volatil incluant une grille flottante (5 ; 103) placée au-dessus d'un substrat semiconducteur (1 ; 103), la grille flottante comprenant des portions actives (6, 41 ; 110) isolées du substrat par des couches isolantes fines (8 ; 102), et des portions inactives (40 ; 111, 112) isolées du substrat par des couches isolantes épaisses (21 ; 107) non traversables par des électrons, **caractérisé en ce que** les portions actives sont majoritairement dopées de type P et les portions inactives comprennent au moins une zone dopée de type N constituant une partie d'une jonction PN.

2. Point mémoire selon la revendication 1, dans lequel les couches isolantes épaisses (21 ; 107) sont placées dans la partie supérieure du substrat (1 ; 100) et isolent plusieurs zones du substrat semiconducteur telles que des caissons (2, 3 ; 107).

3. Point mémoire selon la revendication 1, comprenant en outre des moyens de transfert d'électrons de ladite zone dopées de type N, constituant un puits de stockage d'électrons injectés dans la grille flottante lors d'une opération de programmation, vers tout ou partie des portions actives.

4. Point mémoire selon la revendication 3, dans lequel lesdits moyens de transfert comprennent au moins une électrode de couplage (50, 51) placée à proximité de ladite au moins une zone dopée de type N et séparée de cette dernière par une portion isolante (52, 53), ladite au moins une électrode de couplage étant reliée à une borne de polarisation.

5. Point mémoire selon la revendication 1, dans lequel des premier et second caissons (2, 3) d'un premier type de dopage sont placés dans la partie supérieure du substrat (1) d'un second type de dopage, la grille flottante (5) comprenant une portion active annulaire (6) placée au-dessus du premier caisson, une portion non active (40) placée au-dessus d'une zone isolante (21) placée dans la partie supérieure du substrat entre les premier et second caissons, et une portion active d'extrémité (41) placée au-dessus du second caisson, des zones de drain (10) et de source (11) du second type de dopage étant placées en surface du premier caisson respectivement à l'intérieur et à l'extérieur, en vue de dessus, de la portion active annulaire.

6. Point mémoire selon la revendication 5, dans lequel la portion active annulaire (6) et la portion active d'extrémité (41) sont dopées de type P et la portion inactive (40) est dopée de type N.

7. Point mémoire selon la revendication 5, dans lequel la portion active annulaire (6) et la portion active d'extrémité (41) sont dopées de type P, et la portion inactive comprend plusieurs zones dopées de type N (60, 62, 64) séparées les unes des autres par des zones dopées de type P (61, 63).

8. Point mémoire selon la revendication 5, dans lequel la portion active annulaire (6) et la portion active d'extrémité (41) sont dopées de type P, la portion inactive comprenant une portion rectiligne (80) dopée de type P présentant des excroissances latérales (81 à 88) dont les extrémités (90 à 93) sont dopées de type N.

9. Point mémoire selon les revendications 4 et 7 ou 8, comprenant des zones d'électrode (70, 71 ; 98, 99) placées à proximité de la portion inactive et présentant des excroissances placées à proximité des zones dopées de type N.

10. Point mémoire selon la revendication 1, comprenant un empilement (101) d'une première couche isolante (102), d'une grille flottante (103), d'une seconde couche isolante (104) et d'une grille de contrôle (105), l'empilement étant placé au-dessus d'un substrat semiconducteur (100) perpendiculairement à une bande supérieure (106) du substrat entourée par une zone isolante (107) placée dans la partie supérieure de substrat, des zones de source/drain (108, 109) étant formées dans la bande supérieure de substrat de part et d'autre de l'empilement, la partie centrale (110) de la grille flottante placée au-dessus de la bande supérieure de substrat constituant une portion active dopée de type P, et les portions d'extrémité de la grille flottante constituant des portions inactives dopées de type de N.

## Claims

1. A non-volatile memory point comprising a floating gate (5; 103) placed above a semiconductor substrate (1; 103), the floating gate comprising active portions (6, 41; 110) insulated from the substrate by thin insulating layers (8; 102), and inactive portions (40; 111, 112) insulated from the substrate by thick insulating layers (21; 107) that cannot be crossed by electrons, **characterized in that** at least the main part of the active portions has a P-type doping and the inactive portions comprise at least one N-type doped area forming a portion of a PN junction.

2. The memory point of claim 1, wherein the thick insulating layers (21; 107) are placed in the upper portion of the substrate (1; 100) and insulate several areas of the semiconductor substrate such as wells (2, 3; 107).

3. The memory point of claim 1, further comprising means for electron transfer from said N-type doped area, forming a well of storage of electrons injected into the floating gate in a programming operation, towards all or part of the active portions.

4. The memory point of claim 3, wherein said transfer means comprise at least one coupling electrode (50, 51) placed close to said at least one N-type doped area and separated therefrom by an insulating portion (52, 53), said at least one coupling electrode being connected to a biasing electrode.

5. The memory point of claim 1, wherein first and second wells (2, 3) of a first doping type are placed in the upper portion of the substrate (1) of a second doping type, the floating gate (5) comprising a ring-shaped active portion (6) placed above the first well, a non-active portion (40) placed above an insulating area (21) placed in the upper portion of the substrate between the first and second wells, and an active end portion (41) placed above the second well, drain (10), and source (11) areas of the second doping type being placed at the surface of the first well respectively inside and outside, in top view, of the active ring-shaped portion.

6. The memory point of claim 5, wherein the ring-shaped active portion (6) and the end active portion (41) are P-type doped and the inactive portion (40) is N-type doped.

7. The memory point of claim 5, wherein the ring-shaped active portion (6) and the end active portion (41) are P-type doped, and the inactive portion comprises several N-type doped areas (60, 62, 64) separated from one another by P-type doped areas (61, 63).

8. The memory point of claim 5, wherein the ring-shaped active portion (6) and the end active portion (41) are P-type doped, the inactive portion comprising a P-type doped rectilinear portion (80) exhibiting lateral prominences (81 to 88) having N-type doped ends (90, 93).

9. The memory point of claims 4 and 7 or 8, comprising electrode areas (70, 71; 98, 99) placed close to the inactive portion and exhibiting prominences placed close to the N-type doped areas.

10. The memory point of claim 1, comprising a stack (101) of a first insulating layer (102), a floating gate (103), a second insulating layer (104), and a control gate (105), the stack being placed above a semiconductor substrate (100) perpendicularly to an upper strip (106) of the substrate surrounded by an insulating area (107) placed in the upper substrate portion, source/drain areas (108, 109) being formed in the upper substrate strip on either side of the stack, the central portion (110) of the floating gate placed above the upper substrate strip forming an active P-type doped portion, and the end portions of the floating gate forming inactive N-type doped portions.

## Patentansprüche

1. Nicht flüchtiger Speicherpunkt, der ein schwimmendes Gate bzw. Floating-Gate (5; 103) aufweist, welches über einem Halbleitersubstrat (1; 103) angeordnet ist, wobei das schwimmende Gate aktive Teile (6, 41; 110) aufweist, die von dem Substrat durch dünne isolierende Schichten (8; 102) isoliert sind, und inaktive Teile (40; 111, 112), die von dem Substrat durch dicke isolierende Schichten (21; 107) isoliert sind, die nicht von Elektronen überquert werden können, **dadurch gekennzeichnet, dass** zumindest der Hauptteil der aktiven Teile eine P-Dotierung hat, und dass die inaktiven Teile zumindest einen N-dotierten Bereich aufweisen, wodurch eine PN-Verbindung gebildet wird.

2. Speicherpunkt nach Anspruch 1, wobei die dicken isolierenden Schichten (21; 107) im oberen Teil des Substrates (1; 100) angeordnet sind, und mehrere Bereiche des Halbleitersubstrates isolieren, wie beispielsweise Quellen (2, 3; 107).

3. Speicherpunkt nach Anspruch 1, der weiter Mittel zur Elektronenübertragung von dem N-dotierten Bereich aufweist, wobei eine Quelle (well) zur Speicherung von Elektronen gebildet wird, die in das schwimmende Gate in einem Programmiervorgang eingeleitet werden, und zwar zu allen aktiven Teilen oder einem Teil der aktiven Teile.

4. Speicherpunkt nach Anspruch 3, wobei die Übertragungsmittel zumindest eine Koppelungselektrode (50, 51) aufweisen, die nahe an dem mindestens einen N-dotierten Bereich angeordnet sind und **dadurch** durch einen isolierenden Teil (52, 53) getrennt sind, wobei die mindestens eine Koppelungselektrode mit einer Vorspannungselektrode verbunden ist.

5. Speicherpunkt nach Anspruch 1, wobei erste und zweite Quellen (2, 3) mit einer ersten Dotierungsart im oberen Teil des Substrates (1) einer zweiten Dotierungsart angeordnet sind, wobei das schwimmende Gate bzw. Floating Gate (5) einen ringförmigen aktiven Teil (6) aufweist, der über der ersten Quelle angeordnet ist, einen nicht aktiven Teil (40), der über einem isolierenden Bereich (21) angeordnet ist, der im oberen Teil des Substrates zwischen den ersten und zweiten Quellen angeordnet ist, und einen aktiven Endteil (41), der über der zweiten Quelle angeordnet ist, wobei die Drain-(10) und Source-(11)-Bereiche der zweiten Dotierungsart an der Oberfläche der ersten Quelle jeweils innerhalb und außerhalb, in der Draufsicht des aktiven ringförmigen Teils angeordnet sind.

6. Speicherpunkt nach Anspruch 5, wobei der ringförmige aktive Teil (6) und der aktive Endteil (41) P-dotiert sind, und wobei der inaktive Teil (40) N-dotiert ist.

7. Speicherpunkt nach Anspruch 5, wobei der ringförmige aktive Teil (6) und der aktive Endteil (41) P-dotiert sind, und wobei der inaktive Teil mehrere N-dotierte Bereiche (60, 62, 64) aufweist, die voneinander durch P-dotierte Bereiche (61, 63) getrennt sind.

8. Speicherpunkt nach Anspruch 5, wobei der ringförmige aktive Teil (6) und der aktive Endteil (41) P-dotiert sind, und wobei der inaktive Teil einen P-dotierten rechteckigen Teil (80) aufweist, der seitliche Vorsprünge (81 bis 88) mit N-dotierten Enden (90, 93) zeigt.

9. Speicherpunkt nach den Ansprüchen 4 und 7 oder 8, der Elektrodenbereiche (70, 71; 98, 99) aufweist, die nahe an dem inaktiven Teil angeordnet sind und Vorsprünge zeigen, die nahe an den N-dotierten Bereichen angeordnet sind.

10. Speicherpunkt nach Anspruch 1, der einen Stapel (101) einer ersten isolierenden Schicht (102) eines schwimmenden Gates bzw. Floating-Gates (103), einer zweiten isolierenden Schicht (104) und eines Steuer-Gates (105) aufweist, wobei der Stapel über einem Halbleitersubstrat (100) senkrecht zu einem oberen Streifen (106) des Substrates angeordnet ist, und zwar umgeben durch einen isolierenden Bereich (107), der in dem oberen Substratteil angeordnet ist, wobei Source/Drain-Bereiche (108, 109) in dem oberen Substratstreifen auf jeder Seite des Stapels angeordnet sind, wobei der mittige Teil (110) des Floating-Gates bzw. schwimmenden Gates über dem oberen Substratstreifen angeordnet ist, wobei ein aktiver P-dotierter Teil gebildet wird, und wobei die Endteile des schwimmenden Gates inaktive N-dotierte Teile bilden.
